# EUROPEAN PATENT APPLICATION

(11) **EP 2 055 672 A1**
(43) Date of publication of application: **06.05.2009**
(21) Application number: 07792744.0
(22) Date of filing: 20.08.2007
(51) Int. Cl.: C01B 31/02, B82B 1/00, H01L 29/06, H01L 29/86, H01L 51/30, H01L 51/40

(54) **n-TYPE SEMICONDUCTOR CARBON NANOMATERIAL, METHOD FOR PRODUCING n-TYPE SEMICONDUCTOR CARBON NANOMATERIAL, AND METHOD FOR MANUFACTURING SEMICONDUCTOR DEVICE**

(30) Priority: 21.08.2006 JP 2006316307
(71) Applicant: Fujitsu Limited, Kawasaki-shi, Kanagawa 211-8588 (JP)
(72) Inventor: ASANO, Koji, Kanagawa, 211-8588 (JP)
(74) Representative: Seeger, Wolfgang
(86) International application number: PCT/JP2007/066131
(87) International publication number: WO 2008/023669

(57) **Abstract**

An n-Type semiconductor carbon nanomaterial is produced by mixing a substance having a functional group such as an amino or alkyl group with an inert gas and reacting a semiconductor carbon nanomaterial (1a) with the mixture under irradiation with VUV to covalently bond the amino or alkyl group to the carbon nanomaterial (1a). The amino or alkyl group covalently bonded to the semiconductor carbon nanomaterial (1a) serves as electron-donating groups to convert the carbon nanomaterial (1a) into an n-type one. According to the invention, since the electron-donating group is covalently bonded, a stable n-type semiconductor carbon nanomaterial (1) is obtained which little changes into a p-type one. Further, since the n-type semiconductor carbon nanomaterial (1) is produced by a dry process, bundling or inclusion of impurities can be suppressed. Therefore, the uniform n-type semiconductor carbon nanomaterial (1) having high reliability and stability can be produced.

## Description

### Technical Field

The present invention relates to an n-type semiconductor carbon nanomaterial, a method for producing the n-type semiconductor carbon nanomaterial, and a method for manufacturing a semiconductor device and, more particularly, to an n-type semiconductor carbon nanomaterial produced by conducting a semiconductor carbon nanomaterial, a method for producing the n-type semiconductor carbon nanomaterial, and a method for manufacturing a semiconductor device.

### Background Art

Carbon nanomaterials such as carbon nanotubes, or graphene sheets and layered products thereof, or carbon nanoribbons have been taken notice of as materials for various sensors such as gas sensors or materials for high-function electronic devices such as single-electron transistors. In the fields such as electronic devices, carbon nanotubes have been attempted to be used as wiring materials for connecting between electrodes or wiring lines, or to be used as electrode materials for channels of semiconductor devices such as FETs (Field Effect Transistor).

For applying the carbon nanomaterials to various electrode materials for semiconductor devices such as FETs, n-type and p-type semiconductor carbon nanomaterials must be produced separately. A generally obtained semiconductor carbon nanomaterial tends to change into a p-type one if left in the atmosphere to cause oxygen (O₂) to be adsorbed thereon. By taking advantage of such characteristics, a p-type semiconductor carbon nanomaterial can be relatively easily produced at present.

An N-type semiconductor carbon nanomaterial can be produced by eliminating oxygen through vacuum heat treatment. In addition, for example, a carbon nanotube can be produced by doping alkali metals such as potassium (K) or by causing a specific substance to be adsorbed during formation of the carbon nanotube (see, for example, Patent Document 1). However, the n-type semiconductor carbon nanomaterials obtained by the above-described methods have insufficient stability and have a strong tendency to change into p-type ones if left untouched.

Several conventional methods chemically modify a carbon nanomaterial by a wet process to change the characteristics of the carbon nanomaterial (see, for example, Patent Documents 2 to 4). In addition, a conventional method changes a conductivity type of an organic semiconductor by a chemical reaction (see, for example, Patent Document 5) or a conventional method fabricates an FET by dispersing a carbon nanomaterial on a predetermined substrate to use the carbon nanomaterial as a channel (see, for example, Patent Document 6).
Patent Document 1: Japanese Laid-open Patent Publication No. 2004-284852
Patent Document 2: Published Japanese translation of a PCT application No. 2004-530646
Patent Document 3: Japanese Laid-open Patent Publication No. 2004-168570
Patent Document 4: Japanese Laid-open Patent Publication No. 2005-3687
Patent Document 5: Japanese Laid-open Patent Publication No. 2004-158710
Patent Document 6: Japanese Laid-open Patent Publication No. 2005-93472

### Disclosure of Invention

### Problems that the Invention is to Solve

A wet process is relatively likely to cause inclusion of impurities from a solvent. This inclusion of impurities inhibits production of an n-type semiconductor carbon nanomaterial and stability of characteristics of the semiconductor carbon nanomaterial, and causes a short life of n-type semiconductivity.

When producing particularly an n-type semiconductor carbon nanotube by a wet process, carbon nanotubes easily bundle in a solvent and therefore, it is difficult to perform a homogeneous and fast reaction. When the reaction is performed under severe conditions or for many hours to attain uniformity of the n-type semiconductor carbon nanotube to be produced and speeding-up of the reaction, the carbon nanotubes are likely to deteriorate.

Therefore, even if the n-type semiconductor carbon nanomaterial obtained by a wet process is applied to a semiconductor device such as an FET, it has been so far difficult to manufacture a device having a desired performance or stability. Further, a wet process has a large environmental load as compared with a dry process.

When producing an n-type semiconductor carbon nanomaterial by a dry process, the above-described methods such as vacuum heat treatment, alkali metal doping or adsorption of a specific substance can be used. However, it has been heretofore extremely difficult for these methods to produce an n-type semiconductor carbon nanomaterial which is stable over long periods of time.

Thus, a method for producing a uniform n-type semiconductor carbon nanomaterial having high stability has never been proposed. This creates a significant barrier to practical application of a carbon nanomaterial to a device.

In view of the foregoing, it is an object of the present invention to provide a uniform n-type semiconductor carbon nanomaterial having high stability and a method for producing the n-type semiconductor carbon nanomaterial.

It is another object of the present invention to provide a method for manufacturing a semiconductor device using the semiconductor carbon nanomaterial.

### Means for Solving the Problems

To accomplish the above-described objects, there is provided an n-type semiconductor carbon nanomaterial. This n-type semiconductor carbon nanomaterial comprises a semiconductor carbon nanomaterial covalently bonded with a functional group serving as an electron-donating group.

According to this n-type semiconductor carbon nanomaterial, the electron-donating group is covalently bonded. Therefore, a stable n-type semiconductor carbon nanomaterial is obtained which little changes into a p-type one.

Further, there is provided a method for producing n-type semiconductor carbon nanomaterials. This method comprises the step of: reacting a gaseous substance with a semiconductor carbon nanomaterial to covalently bond the functional group to the carbon nanomaterial, the gaseous substance containing a substance having a functional group serving as an electron-donating group.

According to this method for producing n-type semiconductor carbon nanomaterials, a gaseous substance or a volatile substance containing a substance having a functional group serving as an electron-donating group is reacted with a semiconductor carbon nanomaterial to thereby covalently bond the electron-donating group to the carbon nanomaterial. Therefore, a stable n-type semiconductor carbon nanomaterial is obtained which little changes into a p-type one. Further, the n-type semiconductor carbon nanomaterial is produced by a dry process. Therefore, an environmental load is reduced as compared with a wet process, and bundling or inclusion of impurities which might occur in a wet process can be suppressed.

Further, there is provided a method for manufacturing a semiconductor device using carbon nanomaterials. This method comprises the steps of: (1) forming a semiconductor carbon nanomaterial over a channel region, and (2) covalently bonding a functional group serving as an electron-donating group to the formed carbon nanomaterial.

According to this method for manufacturing a semiconductor device using carbon nanomaterials, a semiconductor carbon nanomaterial is formed over a channel region and a functional group serving as an electron-donating group is covalently bonded to the formed carbon nanomaterial. Therefore, there can be obtained a semiconductor device having as a channel a stable n-type semiconductor carbon nanomaterial which little changes into a p-type one.

### Advantage of the Invention

In the present invention, an electron-donating group is covalently bonded to a semiconductor carbon nanomaterial to impart n-type characteristics to the carbon nanomaterial. On this occasion, a gaseous substance or a volatile substance containing a substance having a functional group serving as an electron-donating group is reacted with the semiconductor carbon nanomaterial to thereby covalently bond the electron-donating group to the carbon nanomaterial. Therefore, there can be produced a uniform n-type semiconductor carbon nanomaterial having high reliability and stability. Further, by using this n-type semiconductor carbon nanomaterial, a semiconductor device having high reliability and stability can be realized.

The above and other objects, features and advantages of the present invention will become apparent from the following description when taken in conjunction with the accompanying drawings which illustrate preferred embodiments of the present invention by way of example.

### Brief Description of Drawings

FIG. 1 shows a structure example of an n-type semiconductor carbon nanomaterial according to the present invention.
FIG. 2 illustrates a principle of a chemical processor.
FIG. 3 shows one example of a VUV lamp peripheral part.
FIG. 4 shows another example of the VUV lamp peripheral part.
FIGS. 5A and 5B show structure examples of a top-gate carbon nanomaterial FET according to the present invention. FIG. 5A is a schematic perspective view and FIG. 5B is a schematic cross-sectional view.
FIG. 6 is a schematic cross-sectional view of a process for forming a source electrode.
FIG. 7 is a schematic cross-sectional view of a process for forming a drain electrode.
FIG. 8 is a schematic cross-sectional view of a process for growing a semiconductor carbon nanotube.
FIG. 9 is a schematic cross-sectional view of a process for producing an n-type semiconductor carbon nanotube.
FIG. 10 is a schematic cross-sectional view of a process for forming a source electrode and a drain electrode.
FIG. 11 is a schematic cross-sectional view of processes for growing a semiconductor graphene sheet and for producing an n-type semiconductor graphene sheet.
FIG. 12 is a schematic cross-sectional view of a process for forming an insulating film.
FIG. 13 is a schematic cross-sectional view of a process for forming a gate electrode.
FIGS. 14A and 14B show structure examples of a back-gate carbon nanomaterial FET according to the present invention. FIG. 14A is a schematic perspective view and FIG. 14B is a schematic cross-sectional view.

### Best Mode for Carrying Out the Invention

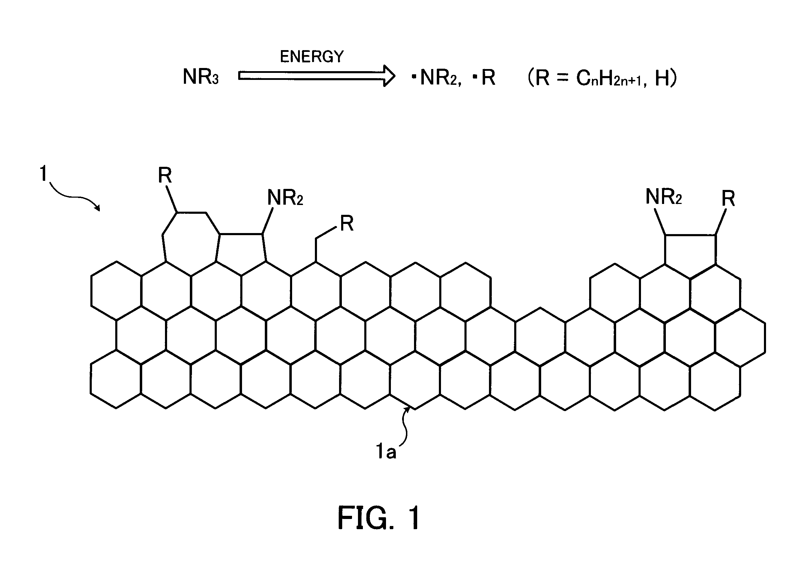

Preferred embodiments of the present invention will be described in detail below with reference to the accompanying drawings, wherein like reference numerals refer to like elements throughout. FIG. 1 shows a structure example of an n-type semiconductor carbon nanomaterial according to the present invention. FIG. 1 shows an essential part of the carbon nanomaterial using a development.

An n-type semiconductor carbon nanomaterial 1 has a structure in which various functional groups (electron-donating groups) exhibiting an electron-donor property, for example, an alkyl group (R=CₙH₂ₙ₊₁) or an amino group (N-R₂ group (R=CₙH₂ₙ₊₁, hydrogen (H)) are covalently bonded to specific sites of a semiconductor carbon nanomaterial 1a.

For producing the n-type semiconductor carbon nanomaterial 1 having this structure, a dry process is here employed. Specifically, the carbon nanomaterial 1a is reacted with a gaseous substance or a volatile substance containing a substance having a functional group that serves as an electron-donating group when being bonded to the carbon nanomaterial 1a, thereby covalently bonding the functional group to specific sites, particularly, specific sites of the surface of the carbon nanomaterial (1a).

"A gaseous substance or a volatile substance" includes not only a substance in a gaseous state near room temperature but also a gaseous mixture in a diluted state, which is obtained by making a high pressure, so-called, a high volatile substance near room temperature into a mist, or a mixture obtained by heating a low pressure, so-called, a low volatile substance near room temperature to a high temperature and then making the substance into a mist. A "reactive gas" includes a mixed gas obtained by diluting the "gaseous substance" with an inert gas. A "dry process" means a process using the above-described substances. The above-described substances are hereinafter described as a "gaseous substance".

The functional group that serves as an electron-donating group when being bonded to the carbon nanomaterial 1a is not basically limited. In addition to an alkyl group or an amino group, examples of the functional group include an alkoxy group (O-R group (R=CₙH₂ₙ₊₁)), a hydroxyl group (OH group) and -R₁-O-R₂ (a functional group containing an ether bond wherein R₁ and R₂ are alkyl groups; and the functional group includes an electron-donating group (for example, -R-O-R (an alkyl group containing an ether bond)) containing hetero elements other than C, such as an ether bond, in the alkyl groups). Examples of the substance having such functional groups include amines (R₁R₂R₃-N (R₁, R₂, R₃=CₙH₂ₙ₊₁, H) wherein R includes an electron-donating group (for example, -R-O-R (an alkyl group containing an ether bond)) containing hetero elements other than C, such as an ether bond); halogenated alkyls (R-X (X=halogen (chlorine (Cl), bromine (Br), iodine (I)) wherein R includes an electron-donating group (for example, -R-O-R (an alkyl group containing an ether bond)) containing hetero elements other than C, such as an ether bond); alcohols (R-OH (R=CₙH₂ₙ₊₁)); and ethers (R₁-O-R₂ ( R₁, R₂=CₙH₂ₙ₊₁) wherein R₁ and R₂ are alkyl groups, and the functional group includes an electron-donating group (for example, -R-O-R (an alkyl group containing an ether bond)) containing hetero elements other than C, such as an ether bond). In the general formula, C is carbon, N is nitrogen, and O is oxygen.

A gaseous substrate containing the above-described substance having the functional group, for example, a mixed gas composed of this substance and an inert gas is reacted with the carbon nanomaterial 1a while being supplied with constant energy, such as under irradiation with VUV (Vacuum Ultra Violet).

In the case of using, for example, VUV as means for supplying energy to the gaseous substrate containing the above-described substance, an excimer UV lamp filled with xenon (Xe) gas can be used. In the excimer UV lamp filled with Xe gas, a generation wavelength has a constant interval, a wavelength distribution is about 150 to 190 nm and a peak wavelength is 172 nm.

When the VUV generated from the Xe excimer UV lamp is irradiated, for example, through a quartz glass to the gaseous substance containing the above-described substance, the VUV having a wavelength of 160 nm or less is almost absorbed into the quartz glass. Therefore, it is appropriate to think that a system using the quartz glass actually uses a Xe excimer UV lamp having a wavelength distribution of 160 to 190 nm.

Photon energy of the VUV emitted at a peak wavelength of 172 nm is about 696kJ/mol. This amount of energy is sufficient to allow many chemical bonds such as C-H bonds or C-N bonds to be cleaved. Bond dissociation enthalpy of the main chemical bond is, for example, as follows. The dissociation enthalpy of the C-H bond is 334 to 464 kJ/mol. The dissociation enthalpy of the C-N bond is 423 kJ/mol. The dissociation enthalpy of the C-O bond of methanol (CH ₃OH) is 378 kJ/mol. Accordingly, the respective chemical bonds exemplified here can be cleaved by irradiation of VUV.

In the environment where the carbon nanomaterial 1a and a gaseous substance containing a substance having a functional group that serves as an electron-donating group when being bonded to the carbon nanomaterial 1a are present, when VUV is irradiated to the gaseous substance, for example, a predetermined chemical bond of the substance is cleaved. As a result, chemically active species such as amino radical (N-R ₂), alkyl radical(R), alkoxy radical (O-R), active oxygen (hydroxyl radical (OH) or singlet oxygen) is generated according to a structure of the substance. When these chemically active species are present near the carbon nanomaterial 1a, since radicals are unstable and highly reactive, they rapidly bond to the carbon nanomaterial 1a, particularly, to the relatively highly reactive sites such as 5-member rings, 7-member rings or radical terminal carbon atoms called dangling bonds. As a result, covalent bonds are formed between a functional group of the substance and the carbon nanomaterial 1a.

Alternatively, when UVU is irradiated in the environment where the carbon nanomaterial 1a and the gaseous substance containing a substance having a functional group that serves as an electron-donating group when being bonded to the carbon nanomaterial 1a are present, a predetermined chemical bond of the substance adsorbed to the carbon nanomaterial 1a is cleaved. As a result, new covalent bonds are formed between a functional group of the substrate and the carbon nanomaterial 1a.

In each case, a functional group bonded to the carbon nanomaterial 1a serves as an electron-donating group to supply electrons into the carbon nanomaterial 1a through covalent bonding, thereby imparting n-type characteristics to the semiconductor carbon nanomaterial 1a. The above-described electron-donating group itself is chemically stable. Further, the covalent bonding formed between the electron-donating group and the carbon nanomaterial 1a is a stable and low-reactive bonding. Therefore, the n-type semiconductor carbon nanomaterial 1 thus covalently bonded with the electron-donating group has a characteristic of hardly changing over time, namely, a characteristic of hardly losing n-type semiconductivity.

This experiment gives a result that when amines such as triethylamine ((CH₃CH₂) ₃N) or a mixture of ammonia (NH₃) and nitrogen (N₂) are reacted with a carbon nanomaterial under irradiation with VUV, the amino groups or derivative groups thereof are introduced into the carbon nanomaterial. Another study has already proved that a semiconductor carbon nanomaterial bonded with an amino group or a derivative group thereof by a wet process exhibits n-type characteristics. Production of the n-type semiconductor carbon nanomaterial will be described in detail later with concrete examples.

Next, a chemical processor used in production of the above-described n-type semiconductor carbon nanomaterial will be described.

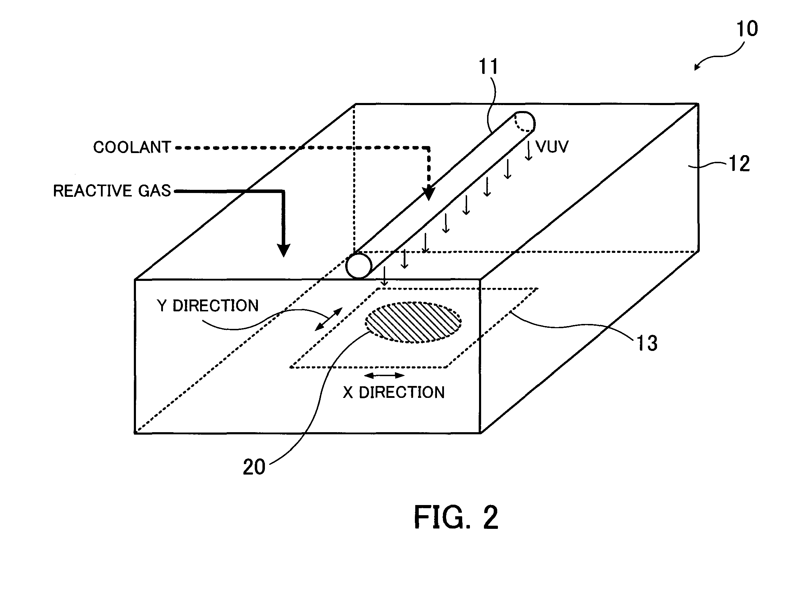

FIG. 2 illustrates a principle of the chemical processor.

The n-type semiconductor carbon nanomaterial can be produced using a chemical processor 10 having a structure as shown in FIG. 2. This chemical processor 10 has a VUV lamp 11 which irradiates VUV and a reaction chamber 12 in which a carbon nanomaterial is placed.

The VUV lamp 11 is designed to be cooled by an appropriate coolant. The reaction chamber 12 internally has a stage 13 for mounting thereon a substrate 20 on which a carbon nanomaterial is formed, for example, by a CVD (Chemical Vapor Deposition) method. This stage 13 has a moving mechanism movable in the X-Y directions, and a temperature controlling mechanism which controls a temperature of the mounted substrate 20.

The reaction chamber 12 is designed to allow introduction of a gas (reactive gas) containing a substance having a functional group that serves as an electron-donating group when being bonded to the carbon nanomaterial. Specifically, the substrate 20 is mounted on the stage 13 within the reaction chamber 12 and then, a reactive gas containing such a substance is introduced into the reaction chamber 12 under irradiation with VUV from the VUV lamp 11, thereby reacting the substance and the carbon nanomaterial on the substrate 20.

A structure example of a peripheral part of the VUV lamp 11 in the chemical processor 10 having the above-described structure will be described here.

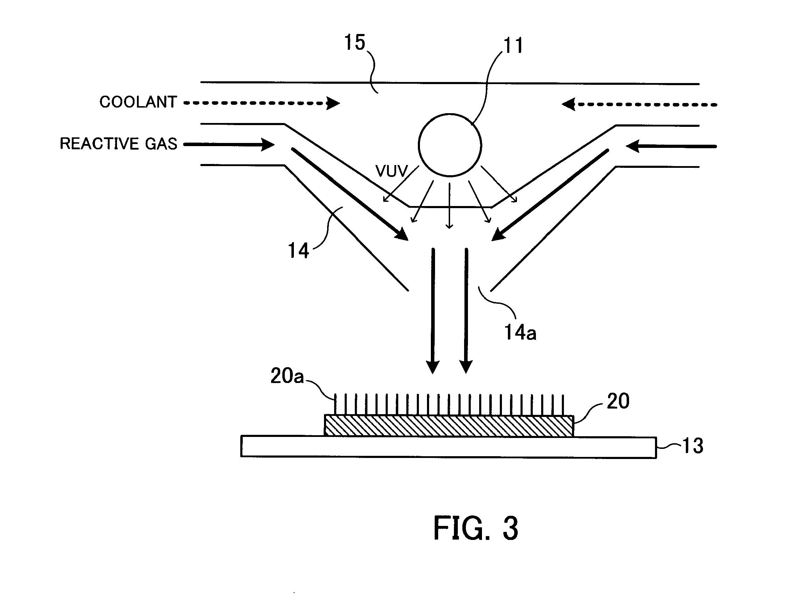

FIG. 3 shows one example of a peripheral part of the VUV lamp 11.

The chemical processor 10 has, for example, a structure as shown in FIG. 3. Specifically, a reactive gas introducing path 14 is provided which has a discharge port 14a formed opposite to the stage 13. The VUV lamp 11 is disposed near the side of the reactive gas introducing path 14 opposite to the discharge port 14a. In this case, a wall member of at least the VUV lamp 11 side of the reactive gas introducing path 14 is made of a material having high VUV transmittance, for example, a member transparent to VUV, such as silica glass, calcium fluoride (CaF₂) or magnesium fluoride (MgF₂). The entire of the reactive gas introducing path 14 may be made of such a material having high VUV transmittance.

Examples of a lamp usable as the VUV lamp 11 include a Xe-filled excimer UV lamp that generates VUV at a peak wavelength of 172 nm. Various shapes of lamps can be used as the VUV lamp 11. For example, a cylindrical one can be used. A shape of the discharge port 14a of the reactive gas introducing path 14 is selected according to a shape of the VUV lamp 11 used.

The VUV lamp 11 is disposed within a coolant passage 15 through which an appropriate coolant, for example, an inert gas such as argon (Ar) or N ₂ absorbing no VUV is appropriately circulated to cool the VUV lamp 11.

When the peripheral part of the VUV lamp 11 is formed to have the structure as shown in FIG. 3, processing for producing the n-type semiconductor carbon nanomaterial is performed as follows. First, the substrate 20 is mounted on the stage 13. Then, a reactive gas is introduced into the reactive gas introducing path 14 under irradiation with VUV from the VUV lamp 11. The reactive gas introduced is the above-described gaseous substance containing a substance having a predetermined functional group such as an amino group or an alkyl group. This substance is mixed with an inert gas and introduced into the reactive gas introducing path 14. When introducing the reactive gas into the reaction chamber 12, the respective temperatures of the reactive gas, the reaction chamber 12 inside and the substrate 20 are suitably controlled according to reaction conditions.

The reactive gas that circulates through the reactive gas introducing path 14 is activated, for example, by VUV irradiated through a wall member of the reactive gas introducing path 14 and generates radicals (amino radicals or alkyl radicals). The radicals are sprayed toward the substrate 20 from the discharge port 14a and the sprayed radicals react with a carbon nanomaterial 20a on the substrate 20 to thereby covalently bond a functional group such as an amino group or an alkyl group to the carbon nanomaterial 20a. If the carbon nanomaterial 20a has semiconductivity, since the bonded functional group serves as an electron-donating group, the semiconductor carbon nanomaterial 20a has n-type characteristics. FIG. 3 exemplifies a carbon nanotube as the carbon nanomaterial 20a on the substrate 20.

If the entire of the reactive gas introducing path 14 is made of a material having high VUV transmittance, energy can be supplied to the reactive gas discharged from the discharge port 14a or to the carbon nanomaterial 20a. As a result, a generation rate of radicals and a reaction rate of the carbon nanomaterial 20a can be improved.

The above-described processing may be performed while moving the stage 13 having mounted thereon the substrate 20 in the X-Y directions according to a shape of the discharge port 14a to attain uniform processing.

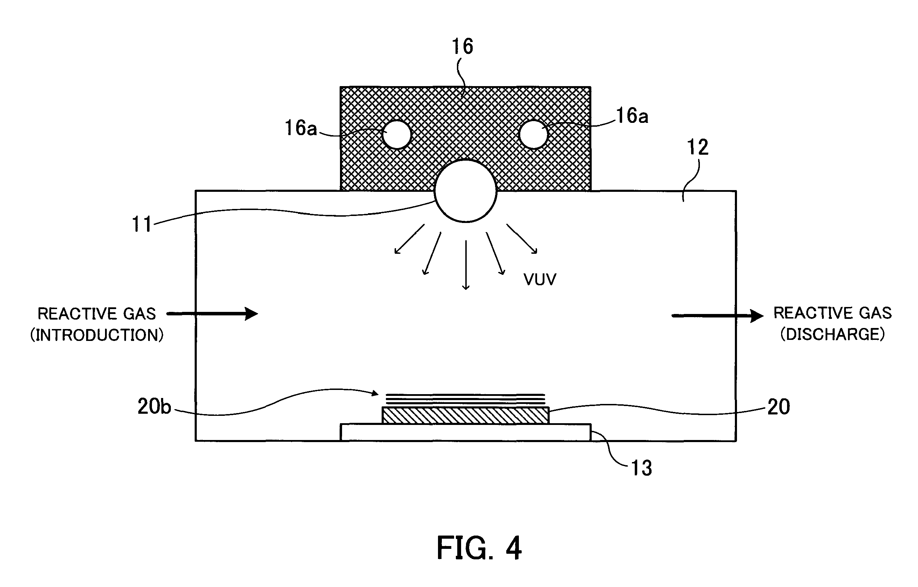

FIG. 4 shows another example of the VUV lamp peripheral part. FIG. 4 exemplifies a graphene sheet as the carbon nanomaterial 20b on the substrate 20.

The chemical processor 10 has, for example, a structure as shown in FIG. 4. Specifically, the VUV lamp 11 such as a Xe excimer UV lamp is disposed on the ceiling part of the reaction chamber 12 and provided with a cooling mechanism comprising a metal block 16 internally having a coolant passage 16a. Further, the reaction chamber 12 is designed to allow circulation (introduction and discharge) of a reactive gas.

The reactive gas that can be circulated is a mixture obtained by mixing the above-described substance having a functional group such as an amino group or an alkyl group with an inert gas. Through the coolant passage 16a, a liquid coolant such as water may be circulated in addition to an inert gas such as N₂.

When the peripheral part of the VUV lamp 11 is formed to have the structure as shown in FIG. 4, processing for producing the n-type semiconductor carbon nanomaterial is performed as follows. First, the substrate 20 is mounted on the stage 13 within the reaction chamber 12. Then, a reactive gas is circulated within the reaction chamber 12 under irradiation with VUV from the VUV lamp 11. When circulating the reactive gas within the reaction chamber 12, the respective temperatures of the reactive gas, the reaction chamber 12 inside and the substrate 20 are suitably controlled according to reaction conditions.

The reactive gas that circulates within the reaction chamber 12 is activated, for example, by VUV irradiation and generates radicals (amino radicals or alkyl radicals). The radicals react with the carbon nanomaterial 20b on the substrate 20 to thereby covalently bond a functional group such as an amino group or an alkyl group to the carbon nanomaterial 20b. If the carbon nanomaterial 20b has semiconductivity, since the bonded functional group serves as an electron-donating group, the semiconductor carbon nanomaterial 20b has n-type characteristics.

Thus, the chemical processor 10 can be formed to have a relatively simple structure except for the VUV irradiation mechanism of the VUV lamp 11 peripheral part, so that the processing itself can be performed at low cost. Further, the reaction conditions can be relatively easily controlled, and inclusion of impurities during the processing can be prevented. As a result, an n-type semiconductor carbon nanomaterial having high reliability can be stably produced.

When producing the n-type semiconductor carbon nanomaterial using the chemical processor 10 having the principle structures shown in FIGS. 2 to 4, it is preferable to set an introduction temperature of the reactive gas to a temperature where a substance having a functional group such as an amino group or an alkyl group is vaporized or isolated near a sample, for example, a temperature lower than the boiling point of the substance by about 10 to 50°C. Alternatively, it is preferable to transfer the vaporized or isolated reactive gas composition near the sample. It is very preferable to irradiate VUV in such a state.

Further, when producing the n-type semiconductor carbon nanomaterial using the chemical processor 10, physical and chemical properties (for example, device characteristics of a semiconductor device such as a transistor manufactured by using the n-type semiconductor carbon nanomaterial, or chemical characteristics of the n-type semiconductor carbon nanomaterial) of the resulting n-type semiconductor carbon nanomaterial can be controlled in detail by changing a type of the substance used as the reactive gas without changing the basic procedures.

For example, by using a substance obtained by substituting an alkyl group in a substance used as the reactive gas with a methyl group, an ethyl group or a propyl group, that is, by selecting substances having very similar chemical properties but having different vapor pressures, the reaction conditions can be controlled. Further, various n-type semiconductor carbon nanomaterials having different characteristics can be separately produced.

Further, when producing the n-type semiconductor carbon nanomaterial using the chemical processor 10, it is desirable to use as the reactive gas a mixed gas obtained by diluting the above-described substance having a functional group such as an amino group or an alkyl group with an inert gas.

For the purpose of securing the stability of optimum reaction conditions, it is desirable to suitably secure a distance between the VUV lamp 11 and the substrate 20, that is, to secure above a certain working distance (distance between a light source and a sample). However, the above-described substance having a functional group suitable for this chemical processing often has a large VUV absorption coefficient. Further, the VUV have large absorption coefficients in air and therefore, are often absorbed within a distance of from 1 to several centimeters from a light source.

Accordingly, it is desirable to dilute the above-described substance having a predetermined functional group with an inert gas. A concentration of this substance in the mixed gas is set, for example, between 0.0001 and 50%, preferably between 0.01 and 10%. The concentration is set based on a type of the substance, an introduction temperature of the reactive gas, a temperature within the reaction chamber 12, a temperature of the substrate 20, and other various reaction conditions.

As described above, a dry process is used for producing the n-type semiconductor carbon nanomaterial. Specifically, a semiconductor carbon nanomaterial is reacted with a gaseous substance containing a substance having a functional group serving as an electron-donating group to thereby covalently bond the functional group to a specific site of the carbon nanomaterial.

When using such a dry process, the n-type semiconductor carbon nanomaterial can be produced at low cost using a relatively simple processor.

Further, inclusion of impurities can be effectively suppressed and an environmental load can be reduced as compared with the production of the n-type semiconductor carbon nanomaterial by a wet process. Further, although the wet process has failed to eliminate particularly the problem of bundling of carbon nanotubes during the processing, the above-described dry process can eliminate such a trouble during the processing.

Accordingly, when using a dry process, the n-type semiconductor carbon nanomaterial having high reliability can be simply and stably produced at low cost.

Further, in the production of the n-type semiconductor carbon nanomaterial by such a dry process, the structure of a reactive substance or the reaction conditions employed when using the reactive substance can be finely changed and thereby, the reaction or the characteristics of the n-type semiconductor carbon nanomaterial can be controlled.

The chemical processor 10 can produce an n-type semiconductor carbon nanomaterial and at the same time, can also produce a p-type semiconductor carbon nanomaterial. Specifically, a reactive gas is introduced which has various functional groups (electron-withdrawing groups) in place of the above-described electron-donating groups and which exhibits an electron-withdrawing property when being bonded to the carbon nanomaterial. Then, the substance and a carbon nanomaterial on the substrate 20 are reacted under irradiation with VUV from the VUV lamp 11 to thereby form a covalent bond between the electron-withdrawing group and the carbon nanomaterial. As a result, the electron-withdrawing group bonded to the carbon nanomaterial draws electrons from the carbon nanomaterial through the covalent bond and imparts p-type characteristics to the semiconductor carbon nanomaterial. Thus, the p-type semiconductor carbon nanomaterial can be produced. Similarly to the case of producing the n-type semiconductor carbon nanomaterial, the covalent bond formed between the electron-withdrawing group and the carbon nanomaterial is stable and low reactive. Therefore, the p-type semiconductor carbon nanomaterial thus covalently bonded with the electron-withdrawing group has a property of hardly changing over time, that is, a property of preserving p-type semiconductor characteristics.

In this case, for example, 1% oxygen gas is introduced as the reactive gas. Then, the oxygen gas and the graphene sheet are reacted under irradiation with VUV in the same manner as in the above-described example and thereby, a carboxyl group (-COOH group) as an electron-withdrawing group is covalently bonded to a specific site, particularly, to a specific site of the surface of the graphene sheet. Thus, a p-type semiconductor graphene sheet can be produced.

A method for producing the n-type semiconductor carbon nanomaterial by a dry process is described above. This method can be easily applied to an FET fabrication process.

For example, an n-channel FET is fabricated by the following process. First, a semiconductor carbon nanomaterial is formed over a region (channel region) serving as a channel between the source electrode and the drain electrode. Then, the semiconductor carbon nanomaterial is reacted with a gaseous substance containing a substance having a predetermined functional group to produce an n-type semiconductor carbon nanomaterial, and the produced n-type semiconductor carbon nanomaterial is used as a channel. This method can be applied to fabrication of any of the n-channel FETs having a top-gate structure and a back-gate structure as exemplified above.

When using the n-type semiconductor carbon nanomaterial as a channel material as described above, device stabilization may be achieved by forming a passivation film on a surface at an appropriate stage according to the structure of the n-channel FET. Materials and forming conditions of the passivation film are not particularly limited as long as they do not cause any deterioration of the carbon nanomaterial.

When fabricating a p-channel FET, the above-described p-type semiconductor carbon nanomaterial can be applied to the FET.

The above-described application example of the n-type semiconductor carbon nanomaterial to the FET will be described here.

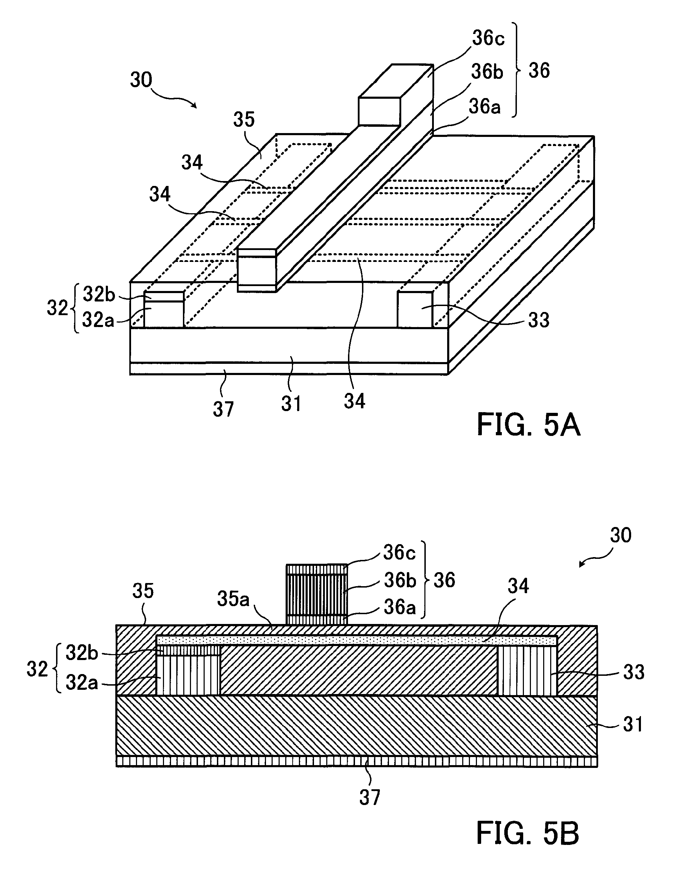

FIGS. 5A and 5B show structure examples of a top-gate carbon nanomaterial FET. FIG. 5A is a schematic perspective view and FIG. 5B is a schematic cross-sectional view.

An n-channel FET 30 shown in FIG. 5 comprises an insulating substrate, for example, a sapphire substrate 31, a source electrode 32 formed on the sapphire substrate 31 and having a catalytic action, a drain electrode 33 formed on the sapphire substrate 31 so as to face the source electrode 32, and n-type semiconductor carbon nanomaterials 34 formed over channel regions between the source electrode 32 and the drain electrode 33. The n-type semiconductor carbon nanomaterials 34 are covered with an insulating film, for example, an SOG (Spin On Glass) film 35. Portions of the SOG film 35, which cover the surface of the n-type semiconductor carbon nanomaterial 34, act as a gate insulating film 35a, and a gate electrode 36 is formed on the gate insulating film 35a. Further, an earth electrode 37 is formed on the back surface of the sapphire substrate 31.

FIG. 5 shows the case where the n-type semiconductor carbon nanomaterials 34 are n-type semiconductor carbon nanotubes. In the case where the n-type semiconductor carbon nanomaterials 34 are n-type semiconductor graphene sheets, a layer below the n-type semiconductor carbon nanomaterials 34 must be an SOG film or other insulating materials such as an insulator.

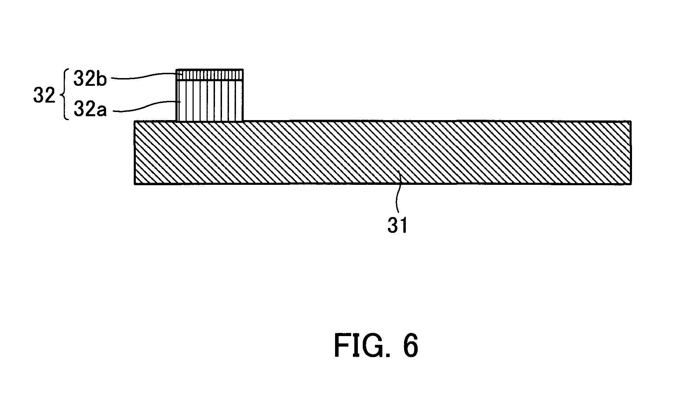

The n-channel FET 30 having the above-described structure can be fabricated, for example, through processes as shown in the following FIGS. 6 to 14.

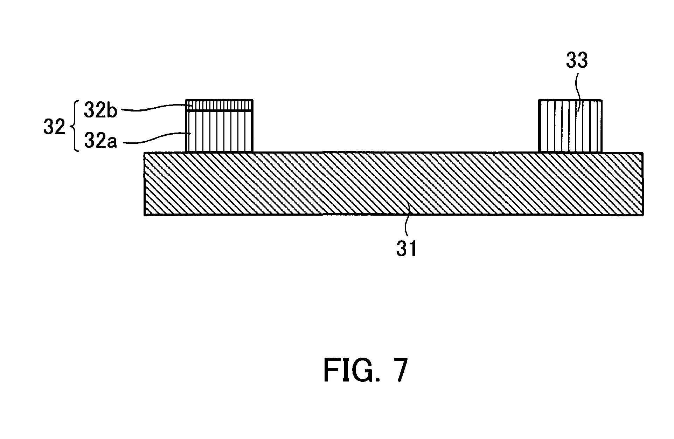

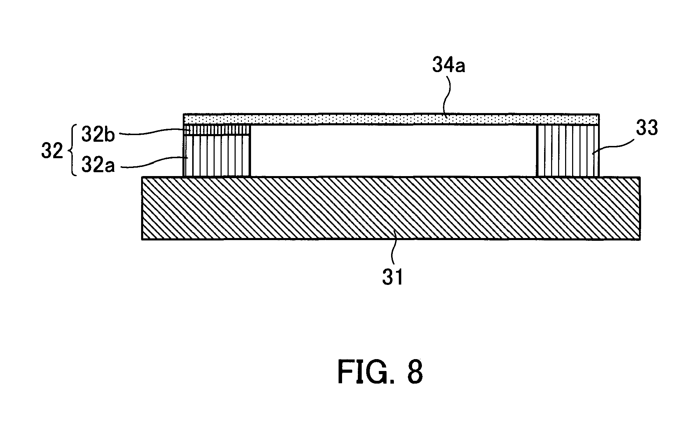

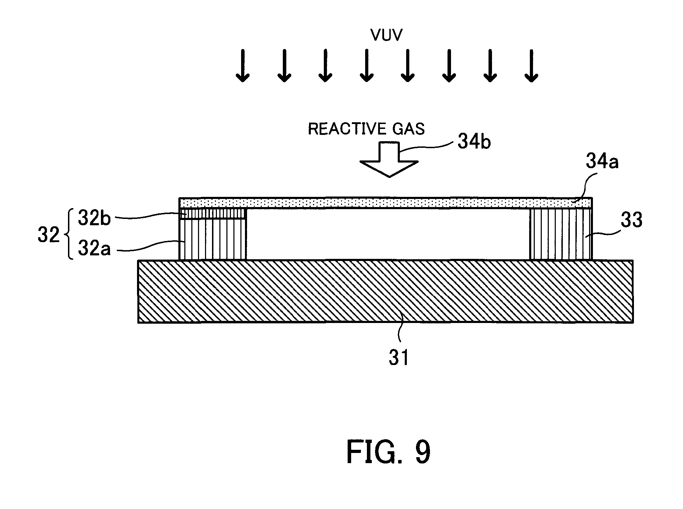

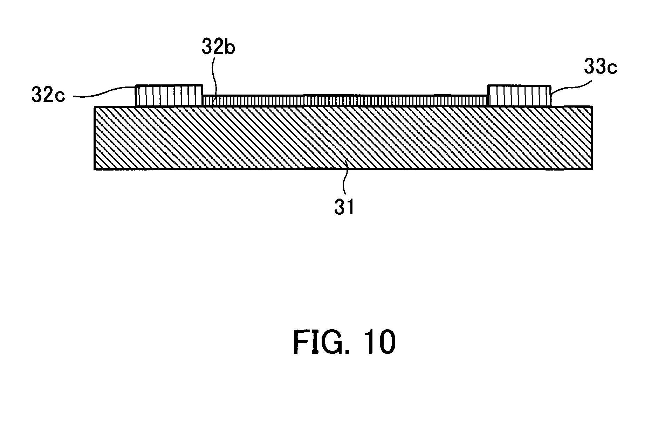

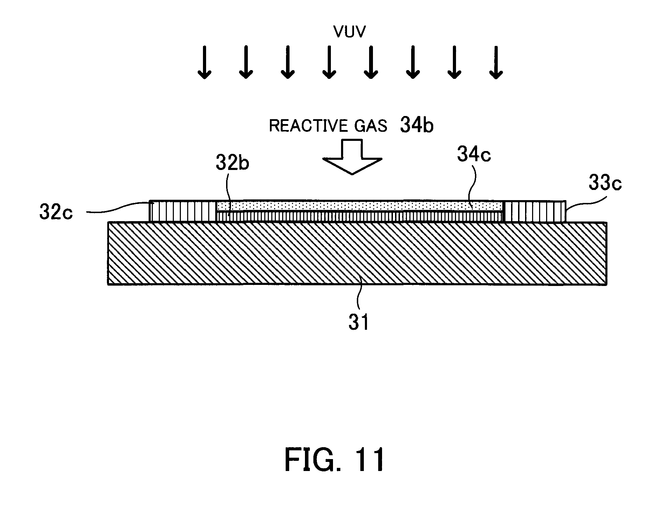

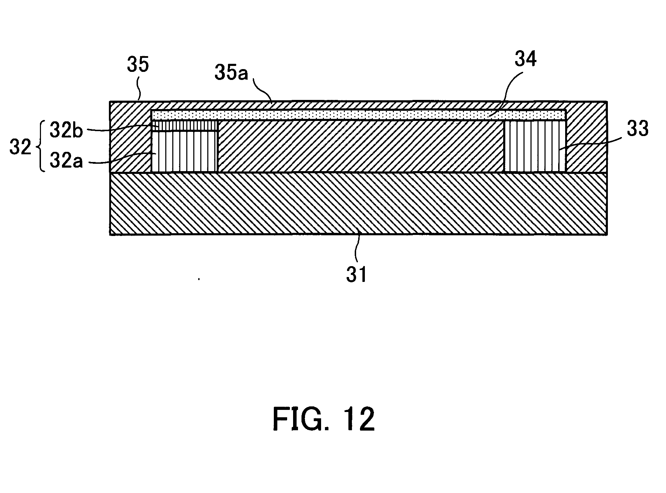

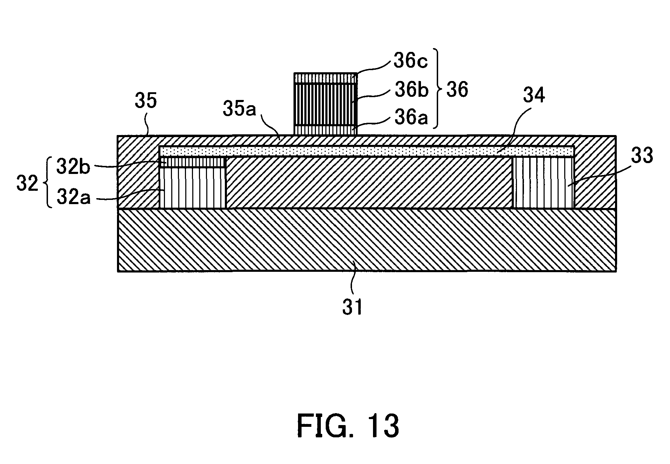

FIG. 6 is a schematic cross-sectional view of a process for forming a source electrode. FIG. 7 is a schematic cross-sectional view of a process for forming a drain electrode. FIG. 8 is a schematic cross-sectional view of a process for growing a semiconductor carbon nanotube. FIG. 9 is a schematic cross-sectional view of a process for producing an n-type semiconductor carbon nanotube. FIG. 10 is a schematic cross-sectional view of a process for forming a source electrode and a drain electrode. FIG. 11 is a schematic cross-sectional view of processes for growing a semiconductor graphene sheet and for producing an n-type semiconductor graphene sheet. FIG. 12 is a schematic cross-sectional view of a process for forming an insulating film. FIG. 13 is a schematic cross-sectional view of a process for forming a gate electrode.

In the n-channel FET 30, the production process of the carbon nanomaterials formed between the source electrode 32 and the drain electrode 33 depends on either carbon nanotubes or graphene sheets. Each production process of the carbon nanotubes and the graphene sheets will be described below.

A production process of carbon nanotubes as carbon nanomaterials will be described.

First, as shown in FIG. 6, an aluminum (Al) film 32a having, for example, a thickness of 5 nm and an iron (Fe) film 32b having, for example, a thickness of 1 nm are sequentially deposited over the sapphire substrate 31 by a sputtering method using a resist pattern (not shown in the figure) as a mask. Thereafter, the resist pattern is removed. Thus, the source electrode 32 is formed. The Fe film 32b acts as a catalyst during the growth of a carbon nanotube 34a.

Next, as shown in FIG. 7, by a sputtering method using again the resist pattern (not shown in the figure) as a mask, an Al film having, for example, a thickness of 6 nm is deposited so as to face the source electrode 32 while leaving a space of, for example, 5 µm therebetween. Thereafter, the resist pattern is removed. Thus, the drain electrode 33 is formed.

Next, as shown in FIG. 8, by a CVD method using acetylene (C₂H₂) gas as a process gas and using Ar gas or H₂ gas as a carrier gas, a plurality of carbon nanotubes 34a are grown while applying a DC electric field between the source electrode 32 and the drain electrode 33 (channel region), for example, under a pressure of 100 Pa and a growth temperature of 600°C.

At this time, at the growth temperature of 600°C, the Fe film 32b constituting the surface of the source electrode 32 is broken into particles under the influence of temperature and the particle diameter is reduced in a reflection of the wettability with the lower Al film 32a. As a result, the grown carbon nanotubes 34a form into semiconductor single wall carbon nanotubes.

In the growth process, since the DC electric field is applied between the source electrode 32 and the drain electrode 33, the carbon nanotubes 34a begin to grow toward the drain electrode 33 from the upper Fe film 32b of the source electrode 32. Then, the carbon nanotubes 34a complete the growth when sufficiently reaching the drain electrode 33. The growth time is, for example, 40 minutes.

Next, as shown in FIG. 9, the grown semiconductor carbon nanotubes 34a are reacted with a reactive gas 34b containing the above-described substance having a predetermined functional group, for example, under irradiation with VUV to thereby produce the n-type semiconductor carbon nanotubes 34a serving as channels. On this occasion, the chemical processor 10 having the above-described structure can be used.

A production process of graphene sheets as carbon nanomaterials will be described.

First, as shown in FIG. 10, a gold (Au) film having, for example, a thickness of 3 nm is deposited on an insulator, for example, on the sapphire substrate 31 by a sputtering method using a resist pattern (not shown in the figure) as a mask. Thereafter, the resist pattern is removed. Thus, a source electrode 32c and a drain electrode 33c are formed while leaving a space of, for example, 5 µm therebetween and the Fe film 32b having, for example, a thickness of 1 nm is formed between the source electrode 32c and the drain electrode 33c.

Next, as shown in FIG. 11, graphene sheets 34c are grown by a conventionally known method using the Fe film 32b as a catalyst. Then, the grown semiconductor graphene sheets 34c are reacted with the reactive gas 34b under irradiation with VUV in the same manner as in the case of producing the n-type carbon nanotubes 34a by the chemical processor 10. Thus, the n-type semiconductor graphene sheets 34c are produced.

Through the above-described production process, the n-type semiconductor carbon nanomaterial 34 is produced between the source electrode 32 and the drain electrode 33 in the n-channel FET 30. The following production process can be applied commonly to the carbon nanotubes 34a and the graphene sheets 34c. The production process subsequent to FIG. 9 will be described below.

Next, as shown in FIG. 12, the SOG film 35 is deposited to have, for example, a thickness of 10 nm on the surface of the n-type semiconductor carbon nanomaterial 34 so as to cover the n-type semiconductor carbon nanomaterial 34 by a spin coat method and an annealing method, thereby forming as the gate insulating film 35a a portion deposited on the n-type semiconductor carbon nanomaterial 34.

Next, as shown in FIG. 13, a titanium (Ti) film 36a having, for example, a thickness of 10 nm, a platinum (Pt) film 36b having, for example, a thickness of 100 nm, and a titanium (Ti) film 36c having, for example, a thickness of 10 nm are sequentially deposited by a sputtering method using a resist pattern (not shown in the figure) as a mask. Thereafter, the resist pattern is removed. Thus, the gate electrode 36 is formed.

Finally, the earth electrode 37 made of aluminum is provided on the back surface of the sapphire substrate 31. Thus, the n-channel FET 30 having a structure shown in FIG. 5 is fabricated.

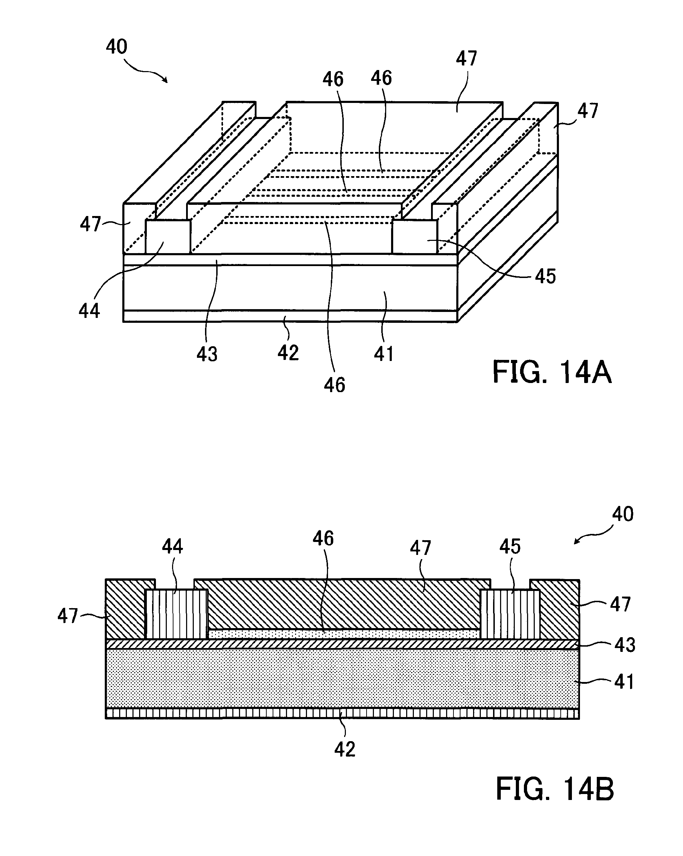

FIGS. 14A and 14B show structure examples of a back-gate carbon nanomaterial FET. FIG. 14A is a schematic perspective view and FIG. 14B is a schematic cross-sectional view.

An n-channel FET 40 shown in FIG. 14 uses as a gate electrode a conductive substrate, for example, a highly doped silicon (Si) substrate 41. On one surface (back surface) of the Si substrate 41, a back-gate metal layer 42 using Ti or Pt is provided. On another surface (surface) thereof, for example, a silicon oxide (SiO₂) film 43 serving as a gate insulating film is provided. On the SiO₂ film 43, a source electrode 44 having a catalytic action and a drain electrode 45 are provided to face each other while leaving a predetermined space therebetween (a catalytic layer is not shown in the figure). N-type semiconductor carbon nanomaterials 46 serving as a channel are provided between the source electrode 44 and the drain electrode 45. The n-type semiconductor carbon nanomaterials 46 are covered with a passivation film 47.

The n-channel FET 40 having the above-described structure is fabricated, for example, by the following process. First, the SiO₂ film 43 is formed on the surface of the Si substrate 41. Then, the source electrode 44 having a layered structure of, for example, a Fe film and an Al film and the drain electrode 45 are formed on the SiO₂ film 43. Then, the semiconductor carbon nanomaterials are grown between the source electrode 44 and the drain electrode 45 (channel region). At this time, both ends of the carbon nanomaterials may be formed on the upper surfaces of the source electrode 44 and the drain electrode 45, respectively (not shown in the figure).

The thus formed semiconductor carbon nanomaterials are reacted with a reactive gas containing the above-described substance having a predetermined functional group, for example, under irradiation with VUV to thereby produce the n-type semiconductor carbon nanomaterials 46 serving as channels. On this occasion, the chemical processor 10 having the above-described structure can be used.

After producing the n-type semiconductor carbon nanomaterials 46, they are covered with the passivation film 47. Further, the back-gate metal layer 42 is formed on the back surface of the Si substrate 41. Thus, the n-channel FET 40 having a structure shown in FIG. 15 is fabricated.

A complementary FET using semiconductor carbon nanomaterials is fabricated, for example, by the following process. First, the semiconductor carbon nanomaterials are formed over the channel regions disposed between regions for fabricating a p-channel FET and an n-channel FET, respectively. Then, a region for fabricating the p-channel FET is masked and a region for fabricating the n-channel FET is exposed using a photolithography method. In such a state, the carbon nanomaterials formed on the n-channel FET side are reacted with a gaseous substance containing a substance having a predetermined functional group to thereby produce the n-type semiconductor carbon nanomaterials. Thus, the p-type semiconductor carbon nanomaterials are formed on the p-channel FET side and the n-type semiconductor carbon nanomaterials are formed on the n-channel FET side, so that the p-type and n-type channels can be separately formed. This method can be applied to fabrication of any of the complementary FETs having a top-gate structure and a back-gate structure as exemplified above.

The above-described separate formation method can be similarly applied to a case of fabricating plural types of FETs using, as channels, the n-type semiconductor carbon nanomaterials having different characteristics. Further, this method can be similarly applied to a case of mixedly mounting a FET using carbon nanomaterials and a FET not using carbon materials on the same substrate.

When forming the carbon nanomaterials in the fabrication of FETs, there may be performed processing for paying attention to the presence of metallic carbon nanomaterials which may be formed together with the semiconductor carbon nanomaterials and for burning out, after the formation of the carbon nanomaterials, the metallic carbon nanomaterials by flowing high current, if necessary.

As examples of the n-type semiconductor carbon nanomaterials, production of n-type semiconductor carbon nanotubes and n-type semiconductor graphene sheets by the above-described dry process will be described below, respectively.

First, the n-type semiconductor carbon nanotube will be described.

The carbon nanotube to be processed may be a single wall carbon nanotube (SWNT), a double wall carbon nanotube (DWNT), or a multi wall carbon nanotube (MMNT). Further, all forms of carbon nanotubes suitable for the manufacturing process of a semiconductor device, such as a carbon nanotube directly grown on the substrate or a carbon nanotube produced by applying or dispersing the formed carbon nanotube on the substrate, can be used as the carbon nanotube to be processed.

### <First Embodiment>

The above-described chemical processor 10 shown in FIGS. 2 and 3 is used. The chemical processor 10 has a Xe excimer UV lamp as the VUV lamp 11 that generates VUV with an output of 30 mW/cm², an emission wavelength of 400 nm, and a peak wavelength of 172 nm.

An Si wafer (p type, (100) surface) with about 1.5 µm of MWNTs formed thereon is used as a sample. Specifically, a nickel (Ni) film is formed on the Si wafer to a thickness of 25 nm by a sputtering method and then the MWNTs are grown by thermal filament CVD method at 650°C using C₂H₂ gas as the raw material.

This sample is baked at 400°C for about 15 minutes in air to previously remove combustible impurities other than carbon nanomaterials and is then transferred immediately to the chemical processor 10. Thereafter, using as a reactive gas a gaseous substance obtained by diluting (CH₃CH₂)₃N with pure nitrogen to a vapor pressure of 1 atmosphere and an oxygen concentration of about 5 vol%, processing of the MWNTs on the Si wafer is performed by introducing the reactive gas into the reactive gas introducing path 14 at a flow rate of 1L per minute.

The sample before and after this processing is analyzed by an X-ray Photoelectron Spectroscopy (XPS) and an Infrared Spectroscopy (IR). As a result, amino bonds not present in the MWNTs before the processing are confirmed after the processing. That is, formation of amino groups on the carbon nanomaterial is confirmed after the processing.

### <Second Embodiment>

The same chemical processor 10 as that used in the first embodiment is used, and an Si wafer (p-type, (100) surface) with SWNTs formed thereon is used as a sample. The SWNTs are produced on the Si wafer by arc discharge. Thereafter, the baking process is performed under the same conditions as those of the first embodiment.

Using the chemical processor 10 and the sample, processing of the SWNTs on the Si wafer is performed by introducing into the reactive gas introducing path 14 a reactive gas having the same composition and flow rate as those of the reactive gas in the first embodiment. Note, however, that the processing time is 10% of that in the processing of the MWNTs.

The sample before and after this processing is analyzed by the XPS and the IR. As a result, it is confirmed that C-N bonds not present in the SWNTs before the processing are formed after the processing.

### <Third Embodiment>

The same chemical processor 10 as that used in the second embodiment is used, and an FET comprising a channel composed of SWNTs is used as a sample. Using the chemical processor 10 and the sample, processing of the SWNTs is performed by introducing into the reactive gas introducing path 14 a reactive gas having the same composition and flow rate as those of the reactive gases in the first and second embodiments.

The sample before and after this processing is analyzed by the XPS and the IR. As a result, it is confirmed that the SWNTs exhibiting weak p-type characteristics before the processing develop n-type characteristics after the processing. Further, it is confirmed that the SWNTs exhibit the n-type characteristics not only immediately after the processing but also continuously.

### <Fourth Embodiment>

The above-described chemical processor 10 shown in FIGS. 2 and 4 is used. The chemical processor 10 has a Xe excimer UV lamp as the VUV lamp 11 that generates VUV with an output of 30 mW/cm², an emission wavelength of 400 nm, and a peak wavelength of 172 nm.

An Si wafer (p type, (100) surface) with about 10 µm of MWNTs formed thereon is used as a sample. Specifically, a nickel (Ni) film is formed on the Si wafer to a thickness of 25 nm by a sputtering method and then the MWNTs are grown by thermal filament CVD method at 650°C using C₂H₂ gas as the raw material.

This sample is baked at 400°C for 15 minutes in air to previously remove combustible impurities other than carbon nanomaterials and is then transferred immediately to the chemical processor 10. Thereafter, using as a reactive gas a gaseous substance obtained by diluting ethanol (CH₃CH₂OH) with pure nitrogen to a vapor partial pressure of about 1%, processing of the MWNTs on the Si wafer is performed by introducing the reactive gas into the reaction chamber 12 at a flow rate of 1L per minute.

The sample before and after this processing is analyzed by the XPS and the IR. As a result, it is confirmed that a hydroxyl group (0.1% or less) scarcely present in the MWNTs before the processing is formed to be about 2% in terms of a carbon element ratio after the processing.

### <Fifth Embodiment>

The same chemical processor 10 as that used in the fourth embodiment is used, and an Si wafer (p-type, (100) surface) with SWNTs formed thereon is used as a sample. The SWNTs are produced on the Si wafer by arc discharge. Thereafter, the baking process is performed under the same conditions as those of the fourth embodiment.

Using the chemical processor 10 and the sample, processing of the SWNTs on the Si wafer is performed by introducing into the reaction chamber 12 a reactive gas having the same composition and flow rate as those of the reactive gas in the fourth embodiment. Note, however, that the processing time is 10% of that in the processing of the MWNTs.

The sample before and after this processing is analyzed by the XPS and the IR. As a result, it is confirmed that a hydroxyl group scarcely present in the MWNTs before the processing is formed to be about 2% in terms of a carbon element ratio after the processing.

### <Sixth Embodiment>

The same chemical processor 10 as that used in the fifth embodiment is used, and an FET comprising a channel composed of SWNTs is used as a sample. Using the chemical processor 10 and the sample, processing of the SWNTs on the Si wafer is performed by introducing into the reaction chamber 12 a reactive gas having the same composition and flow rate as those of the reactive gases in the fourth and fifth embodiments.

The sample before and after this processing is analyzed by the XPS and the IR. As a result, it is confirmed that the SWNTs exhibiting weak p-type characteristics before the processing develop n-type characteristics after the processing. Further, it is confirmed that the SWNTs exhibit the n-type characteristics not only immediately after the processing but also continuously.

Next, the n-type graphene sheet will be described.

Graphene sheets are inexpensive and stable because of having large electron mobility and no bundle. Further, graphene sheets are easily processed and easily integrated into a planar transistor as compared with carbon nanotubes. The graphene sheet to be processed may be a single-layered or multi-layered graphene sheet. Further, all forms of graphene sheets suitable for the manufacturing process of the semiconductor device, such as a graphene sheet directly grown on the substrate or a graphene sheet produced by applying or dispersing the formed graphene sheet on the substrate, can be used as the graphene sheet to be processed.

Using the chemical processor 10 shown in FIGS. 2 and 3 or FIGS. 2 and 4, the processing of the graphene sheets in place of the carbon nanotubes is performed in the same manner as in the above-described embodiments. Then, the sample before and after the processing is analyzed by the XPS and the IR in the same manner as in the above-described embodiments. As a result, it is confirmed that the n-type graphene sheet is produced.

The foregoing is considered as illustrative only of the principles of the present invention. Further, since numerous modifications and changes will readily occur to those skilled in the art, it is not desired to limit the invention to the exact construction and applications shown and described, and accordingly, all suitable modifications and equivalents may be regarded as falling within the scope of the invention in the appended claims and their equivalents.

### Description of Reference Numerals and Signs

- 1, 34, 46: N-type semiconductor carbon nanomaterial
- 1a, 20a, 20b: Carbon nanomaterial
- 10: Chemical processor
- 11: VUV lamp
- 12: Reaction chamber
- 13: Stage
- 14: Reactive gas introducing path
- 14a: Discharge port
- 15, 16a: Coolant passage
- 16: Metal block
- 20: Substrate
- 30, 40: N-channel FET
- 31: Sapphire substrate
- 32, 32c, 44: Source electrode
- 32a: Al film
- 32b: Fe film
- 33, 33c, 45: Drain electrode
- 34a: Carbon nanotube
- 34b: Reactive gas
- 34c: Graphene sheet
- 35: SOG film
- 35a: Gate insulating film
- 36: Gate electrode
- 36a, 36c: Ti film
- 36b: Pt layer
- 37: Earth electrode
- 41: Si substrate
- 42: Back-gate metal layer
- 43: SiO₂ film
- 47: Passivation film

## Claims

1. An n-type semiconductor carbon nanomaterial, comprising:
a semiconductor carbon nanomaterial covalently bonded with a functional group serving as an electron-donating group.

2. The n-type semiconductor carbon nanomaterial according to claim 1, wherein:
the carbon nanomaterial is a carbon nanotube, or a carbon nanoribbon, or a graphene sheet and a layered product thereof.

3. The n-type semiconductor carbon nanomaterial according to claim 1, wherein:
the functional group is an amino group, an alkyl group, an alkoxy group, a halogenated alkyl group, an alkyl group containing an ether bond, or a hydroxyl group.

4. The n-type semiconductor carbon nanomaterial according to claim 1, wherein:
characteristics of the carbon nanomaterial are controlled by the structure and amount of the covalently bonded functional group.

5. A method for producing n-type semiconductor carbon nanomaterials, comprising:
reacting a gaseous substance with a semiconductor carbon nanomaterial to covalently bond the functional group to the carbon nanomaterial, the gaseous substance containing a substance having a functional group serving as an electron-donating group.

6. The method according to claim 5, wherein:
the carbon nanomaterial is a carbon nanotube, or carbon nanoribbons, or graphene sheet and a layered product thereof.

7. The method according to claim 5, wherein:
the functional group is one of an amino group, an alkyl group, an alkoxy group, a halogenated alkyl group, an alkyl group containing an ether bond, and a hydroxyl group.

8. The method according to claim 5, wherein:
in the reacting, energy required for the functional group to dissociate from the substance contained in the gaseous substance is supplied.

9. The method according to claim 8, wherein:
the energy is VUV.

10. The method according to claim 5, wherein:
the gaseous substance is a mixture of the substance and an inert gas.

11. The method according to claim 5, wherein:
in the reacting, radicals in the functional group are generated from the substance contained in the gaseous substance and the radicals are reacted with the carbon nanomaterial, to covalently bond the functional group to the carbon nanomaterial.

12. The method according to claim 5, wherein:
in the reacting, reaction conditions are controlled according to the structure of the functional group of the substance contained in the gaseous substance.

13. The method according to claim 12, wherein:
characteristics of the carbon nanomaterial are controlled by controlling the reaction conditions.

14. A method for manufacturing a semiconductor device using carbon nanomaterials, comprising:
forming a semiconductor carbon nanomaterial over a channel region, and
covalently bonding a functional group serving as an electron-donating group to the formed carbon nanomaterial.

15. The method according to claim 14, wherein:
the carbon nanomaterial is a carbon nanotube or carbon nanoribbon or graphene sheet and layered product thereof.

16. The method according to claim 14, wherein:
in covalently bonding the functional group to the carbon nanomaterial, a gaseous substance containing a substance having the functional group is reacted with the carbon nanomaterial, to covalently bond the functional group to the carbon nanomaterial.

17. The method according to claim 14, wherein:
when reacting the gaseous substance with the carbon nanomaterial, energy required for the functional group to dissociate from the substance contained in the gaseous substance is supplied.

18. The method according to claim 14, further comprising, before covalently bonding the functional group to the carbon nanomaterial:
forming another carbon nanomaterial over another channel region, and
masking the formed another carbon nanomaterial, wherein:
in covalently bonding the functional group to the formed carbon nanomaterial, the another carbon nanomaterial is masked to covalently bond the functional group to the carbon nanomaterial.
